Europäisches Patentamt

European Patent Office

Office européen des brevets

(11) Veröffentlichungsnummer: **0 286 879 B1**

(12) # EUROPÄISCHE PATENTSCHRIFT

(45) Veröffentlichungstag der Patentschrift: **27.05.92**

(51) Int. Cl.⁵: **G06F 1/04**, G06F 11/16, H03L 7/00

(21) Anmeldenummer: **88104686.6**

(22) Anmeldetag: **23.03.88**

(54) **Integrierte Schaltungsanordnung zur Überwachung eines mitintegrierten Oszillators.**

(30) Priorität: **13.04.87 DE 3712517**

(43) Veröffentlichungstag der Anmeldung:
**19.10.88 Patentblatt 88/42**

(45) Bekanntmachung des Hinweises auf die
Patenterteilung:
**27.05.92 Patentblatt 92/22**

(84) Benannte Vertragsstaaten:
**AT DE FR GB IT LU NL**

(56) Entgegenhaltungen:
**EP-A- 0 006 328**
**DE-A- 2 532 587**
**FR-A- 2 315 736**
**US-A- 3 289 097**
**US-A- 3 708 686**

**THE BELL SYSTEM TECHNICAL JOURNAL,**
**Band 62, Nr. 10, Dezember 1983, Seiten**
**3377-3390; J.M. KIKER, Jr. et al.: "The AR6A**
**single-sideband microwave radio system:**
**Frequency control" *Seite 3378, Zeile 24 -**
**Seite 3380, Zeile 10; Seite 3384, Zeile 17 -**
**Seite 3388, Zeile 38; Figuren 2, 4, 6***

(73) Patentinhaber: **SIEMENS AKTIENGESELL-**
**SCHAFT**
**Wittelsbacherplatz 2**
**W-8000 München 2(DE)**

(72) Erfinder: **Kessler, Heinrich, Dipl.-Phys.**
**Washingtonstrasse 19**
**W-8000 München 19(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung betrifft eine integrierte Schaltungsanordnung zur Überwachung eines mitintegrierten Oszillators, der über ein externes Frequenznormal angeregt, den die Funktion der integrierten Schaltung synchron steuernden Takt liefert.

Integrierte Schaltungen, die durch einen synchronen Takt gesteuert werden, wie z.B. Mikrocontroller, erzeugen die Taktsignale in üblicher Weise durch einen in die Schaltung mitintegrierten Oszillator, dessen Frequenz durch ein externes Frequenznormal, z.B. einen Schwingquarz, festgelegt wird.

Durch einen Bruch des Schwingquarzes oder durch eine Unterbrechung einer vom Frequenznormal zur integrierten Schaltung führenden Leitung gerät der Oszillator außer Kontrolle und die integrierte Schaltung in einen undefinierten Zustand. Beim Ausfall der integrierten Schaltung können von dieser gesteuerte Systeme und Prozesse, beispielsweise Motorsteuerungen in Kraftfahrzeugen oder automatisierte industrielle Fertigungen außer Kontrolle geraten.

Es ist bekannt, solche unkontrollierten System- bzw. Prozeßzusammenbrüche, die auf einen Funktionsausfall der integrierten Schaltung zurückzuführen sind, durch eine vom Anwender aufzubauende, externe Schaltung zu überwachen und gegebenenfalls zu beheben. Nachteilig ist dabei aber, daß der Anwender einerseits detailliertes Wissen über den Aufbau der integrierten Schaltung besitzen muß und andererseits durch die Realisierung der externen Überwachungsschaltung zusätzliche Systemkosten entstehen.

Eine derartige Überwachungsschaltung ist aus der US-3,708,686 bekannt. Sie betrifft eine Einrichtung zur Überwachung eines quarzkristallgesteuerten Oszillators, die zwei Oszillatoren sowie einen Frequenzkomparator aufweist. Es wird dabei immer der mit höherer Frequenz arbeitende Oszillator ausgewählt, um die nachfolgenden Schaltungen mit dem Systemtakt zu versorgen. Immer wenn die Frequenz des gewählten Oszillators zu weit absinkt, wird automatisch auf den anderen Oszillator umgeschaltet.

Der Erfindung liegt die Aufgabe zugrunde, die Frequenz eines mitintegrierten Oszillators unmittelbar zu überwachen, um bei dessen Ausfall die integrierte Schaltung in einen definierten Zustand zu bringen.

Gelöst wird diese Aufgabe bei einer integrierten Schaltungsanordnung der eingangs genannten Art durch einen mitintegrierten Reserve-Oszillator, dessen Maximalfrequenz bei fehlerfreiem Betrieb des Oszillators unter der Minimalfrequenz des Oszillators liegt und einen mitintegrierten Frequenzvergleicher, der die Frequenz des Reserve-Oszillators mit der Frequenz des Oszillators vergleicht und bei Absinken der Frequenz des Oszillators unter die Frequenz des Reserve-Oszillators den die Funktion der integrierten Schaltung synchron steuernden Takt vom Reserve-Oszillator ableitet.

Da die Frequenz des Reserve-Oszillators bei dieser Anordnung lediglich unter der Minimalfrequenz der Oszillators liegen muß und keiner Stabilisierung bedarf, kann für diesen auf ein entsprechendes externes Frequenznormal verzichtet werden. Die Realisierung kann deshalb ausschließlich aus integrierten Schaltungsteilen, beispielsweise einer Schmitt-Trigger-Schaltung erfolgen, die an die Spannungsversorgung der integrierten Schaltung angeschlossen werden können und somit auch keiner eigenen externen Spannungsquelle bedürfen.

Bei einer Fehlfunktion des den mitintegrierten Oszillator anregenden Frequenznormals fällt die Frequenz dieses Oszillators unter die Frequenz des Reserve-Oszillators. Der Frequenzvergleicher registriert diese Unterschreitung und leitet den synchron steuernden Takt für den Funktionsablauf der integrierten Schaltung nunmehr vom Reserve-Oszillator ab. Ein unkontrolliertes Zusammenbrechen des über die integrierte Schaltung gesteuerten Systems oder Prozesses ist dadurch ausgeschlossen.

In einer vorteilhaften Ausgestaltung der Schaltungsanordnung nach der Erfindung kann innerhalb eines Logikteiles beim Ansprechen des Frequenzvergleichers ein Speicherbit gesetzt werden, das den einmal eingetretenen, fehlerhaften Frequenzvergleich speichert und nur durch ein externes Rücksetzsignal in an sich bekannter Weise wieder gelöscht werden kann.

Da beim Einschalten der Versorgungsspannung der Reserve-Oszillator in der Regel schneller anspricht als der an das externe Frequenznormal gekoppelte Oszillator, kann über das externe Rücksetzsignal die Schaltungsanordnung nach dem Einschaltvorgang in einen definierten Ausgangszustand überführt werden.

In einer weiteren Ausführungsform der Schaltungsanordnung läßt sich das Speicherbit schließlich dazu benutzen, einen festgelegten Zustand einzustellen oder einen Notlauf der integrierten Schaltung einzuleiten.

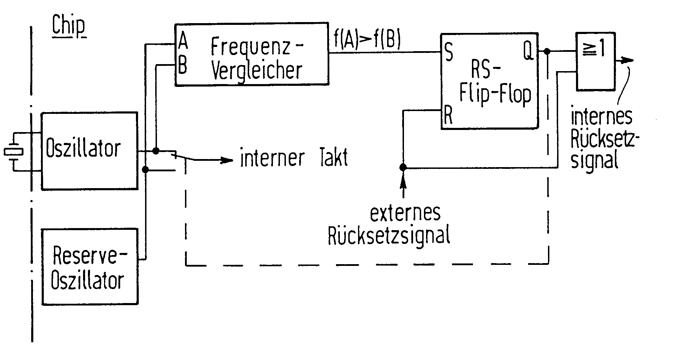

In der Zeichnung ist ein Ausführungsbeispiel des Erfindungsgegenstandes anhand eines Blockschaltbildes näher erläutert.

Ein auf einen Chip mitintegrierter Frequenzvergleicher besitzt zwei Eingänge A und B, an welchen die Frequenzen eines Oszillators, der an einen externen Schwingquarz gekoppelt ist und eines ebenfalls mitintegrierten Reserve-Oszillators liegen. Am Ausgang des Frequenzvergleichers liegt, falls die Frequenz des Reserve-Oszillatros f(A) größer als die Frequenz des Oszillators f(B) ist, ein Signal an, das in einem nachgeschalteten RS-Flip-Flop ein Speicherbit setzt, welches über den Ausgang Q den internen Takt vom Oszillator auf den Reserve-Oszillator umschaltet und gleichzeitig über ein ODER-Gatter ein internes Rücksetzsignal auslöst. Ein extern erzeugtes Rücksetzsignal, das sowohl am R-Eingang des RS-Flip-Flops als auch am zweiten Eingang des ODER-Gatters anliegt, löscht dabei im RS-Flip-Flop das vom Frequenzvergleicher ausgelöste Speicherbit und erzeugt im ODER-Gatter ein internes Rücksetzsignal.

## Patentansprüche

1. Integrierte Schaltungsanordnung zur Überwachung eines mitintegrierten Oszillators, der über ein externes Frequenznormal angeregt, den die Funktion der integrierten Schaltung synchron steuernden Takt liefert, **gekennzeichnet** durch einen mitintegrierten Reserve-Oszillator, dessen Maximalfrequenz bei fehlerfreiem Betrieb des Oszillators unter der Minimalfrequenz des Oszillators liegt, und durch einen mitintegrierten Frequenzvergleicher, der die Frequenz des Reserve-Oszillators mit der Frequenz des Oszillators vergleicht und bei Absinken der Frequenz des Oszillators unter die Frequenz des Reserve-Oszillators den die Funktion der integrierten Schaltung synchron steuernden Takt vom Reserve-Oszillator ableitet.

2. Integrierte Schaltungsanordnung nach Anspruch 1, **dadurch gekennzeichnet**, daß der Reserve-Oszillator ausschließlich aus integrierten Schaltungsteilen besteht.

3. Integrierte Schaltungsanordnung nach Anspruch 1 oder 2, **dadurch gekennzeichnet**, daß der Reserve-Oszillator eine Schmitt-Trigger-Schaltung enthält.

4. Integrierte Schaltungsanordnung nach einem der vorangehenden Ansprüche, **dadurch gekennzeichnet**, daß der Frequenzvergleicher mit einer logischen Schaltung zur Speicherung mindestens eines Speicherbits gekoppelt ist.

5. Verfahren zur Überwachung eines mitintegrierten Oszillators, der über ein externes Frequenznormal angeregt, den die Funktion der integrierten Schaltung synchron steuernden Takt liefert, **dadurch gekennzeichnet,** daß bei Absinken der Frequenz des Oszillators unter die Frequenz eines mitintegrierten Reserve-Oszillators, dessen Maximal frequenz im fehlerfreien Betrieb des Ozillators unter der Minimalfrequenz des Oszillators liegt, durch einen die Frequenz des Reserve-Oszillators mit der Frequenz des Oszillators vergleichenden mitintigrierten Frequenzvergleicher der die Funktion der integrierten Schaltung synchron steuernde Takt vom Reserve-Oszillator abgeleitet wird.

6. Verfahren nach Anspruch 5, **dadurch gekennzeichnet**, daß beim Umschalten vom Oszillator auf den Reserve-Oszillator ein Speicherbit gesetzt wird, das den eingetretenen fehlerhaften Frequenzvergleich speichert und nur durch ein externes Rücksetzsignal wieder gelöscht werden kann.

7. Verfahren nach Anspruch 6, **dadurch gekennzeichnet**, daß das Speicherbit zur Einstellung eines definierten Zustands der Schaltung verwendet wird.

8. Verfahren nach Anspruch 6, **dadurch gekennzeichnet**, daß das Speicherbit zur Einstellung eines Notlaufs der integrierten Schaltung dient.

## Claims

1. Integrated-circuit configuration for monitoring an oscillator integrated in the circuit which, excited via an external frequency standard, furnishes the clock pulse synchronously controlling the function of the integrated circuit, characterised by a reserve oscillator, which is integrated in the circuit and whose maximum frequency is below the minimum frequency of the oscillator in the event of faultless operation of the oscillator, and by a frequency comparator integrated in the circuit, which compares the frequency of the reserve oscillator with the frequency of the oscillator, and when the frequency of the oscillator drops below the frequency of the reserve oscillator derives from the reserve oscillator the clock pulse synchronously controlling the function of the integrated circuit.

2. Integrated-circuit configuration according to Claim 1, characterised in that the reserve oscillator consists exclusively of integrated circuit parts.

3. Integrated-circuit configuration according to Claim 1 or 2, characterised in that the reserve oscillator contains a Schmitt-trigger circuit.

4. Integrated-circuit configuration according to one of the preceding claims, characterised in that the frequency comparator is coupled to a logic circuit for storing at least one memory bit.

5. Method of monitoring an oscillator integrated in the circuit which, excited via an external frequency standard, furnishes the clock pulse synchronously controlling the function of the integrated circuit, characterised in that when the frequency of the oscillator drops below the frequency of a reserve oscillator, which is integrated in the circuit and whose maximum frequency is below the minimum frequency of the oscillator in the event of faultless operation of the oscillator, the clock pulse synchronously controlling the function of the integrated circuit is derived from the reserve oscillator via a frequency comparator, which is integrated in the circuit and compares the frequency of the reserve oscillator with the frequency of the oscillator.

6. Method according to Claim 5, characterised in that upon switching over from the oscillator to the reserve oscillator a memory bit is set which stores the defective frequency comparison that has occurred and can be erased again only by an external reset signal.

7. Method according to Claim 6, characterised in that the memory bit is used to set a defined state of the circuit.

8. Method according to Claim 6, characterised in that the memory bit serves to set an emergency operation of the integrated circuit.

**Revendications**

1. Montage intégré pour contrôler un oscillateur cointégré, qui, excité par l'intermédiaire d'une fréquence étalon externe, fournit la cadence commandant de façon synchrone l'entraînement du circuit intégré, caractérisé par un oscillateur de réserve cointégré, dont la fréquence maximale est, lors d'un fonctionnement sans défaut de l'oscillateur, inférieure a la fréquence minimale de l'oscillateur, et par un comparateur de fréquence intégré conjointement, qui compare la fréquence de l'oscillateur de réserve à la fréquence de l'oscillateur et, lorsque la fréquence de l'oscillateur tombe au-dessous de la fréquence de l'oscillateur de réserve, tire de l'oscillateur de réserve la cadence commandant de façon synchrone le fonctionnement du circuit intégré.

2. Montage intégré suivant la revendication 1, caractérisé par le fait que l'oscillateur de réserve est constitué exclusivement par des éléments de circuits intégrés.

3. Montage intégré suivant la revendication 1 ou 2, caractérisé par le fait que l'oscillateur de réserve comporte un circuit déclencheur de Schmitt.

4. Montage intégré suivant l'une des revendications précédentes, caractérisé par le fait que le comparateur de fréquence est couplé à un circuit logique servant à mémoriser au moins un bit de mémoire.

5. Procédé pour contrôler un oscillateur cointégré, qui, excité par une fréquence étalon externe, fournit la cadence commandant de façon synchrone le fonctionnement du circuit intégré, caractérisé par le fait que, lorsque la fréquence de l'oscillateur tombe au-dessous de la fréquence d'un oscillateur de réserve cointégré, dont la fréquence maximale est inférieure à la fréquence minimale de l'oscillateur, lorsque ce dernier fonctionne sans défaut, la cadence, qui commande de façon synchrone le fonctionnement du circuit intégré, est tirée de l'oscillateur de réserve au moyen d'un comparateur de fréquence cointégré, qui compare la fréquence de l'oscillateur de réserve à la fréquence de l'oscillateur.

6. Procédé suivant la revendication 5, caractérisé par le fait que lors de la commutation de l'oscillateur sur l'oscillateur de réserve, un bit de mémoire est positionné, ce bit mémorisant la comparaison de fréquence erronée apparue et pouvant être à nouveau effacé uniquement par un signal externe de remise à zéro.

7. Procédé suivant la revendication 6, caractérisé par le fait que le bit de mémoire est utilisé pour régler un état défini du circuit.

8. Procédé suivant la revendication 6, caractérisé par le fait que le bit de mémoire est utilisé pour régler un fonctionnement d'urgence du circuit intégré.

Chip

| A | Frequenz- | f(A)>f(B) | S | RS- | Q | ≧1 |
| B | Vergleicher | | | Flip-Flop | | |
| | | | R | | | |

Oszillator

interner Takt

externes
Rücksetzsignal

internes
Rücksetzsignal

Reserve-
Oszillator